# EUROPEAN PATENT APPLICATION

(11) **EP 1 557 438 A1**
(43) Date of publication of application: **27.07.2005**
(21) Application number: 03758833.2
(22) Date of filing: 23.10.2003
(51) Int. Cl.: C08G 59/50, C08G 59/40

(54) **CAPSULE TYPE HARDENER AND COMPOSITION**

(30) Priority: 25.10.2002 JP 2002311114; 24.03.2003 JP 2003079836
(71) Applicant: Asahi Kasei Chemicals Corporation, Tokyo 100-8440 (JP)
(72) Inventor: USUI, Taketoshi, Yokohama-shi, Kanagawa 236-0057 (JP); OHYAMA, Yoshimitsu, Kawasaki-shi, Kanagawa 211-0041 (JP)
(74) Representative: HOFFMANN EITLE
(86) International application number: PCT/JP2003/013571
(87) International publication number: WO 2004/037885

(57) **Abstract**

A capsule type curing agent which comprises a core containing an amine type curing agent (A) and a capsule and a membrane covering said core, wherein said capsule membrane has a bonding group (x) absorbing infrared ray of a wave-number of 1630 to 1680 cm⁻¹ and/or a bonding group (y) absorbing infrared ray of a wave-number of 1680 to 1725 cm⁻¹, and contains cured material of an epoxy resin by the amine type curing agent (A) as a curing agent, and weight ratio of the core and the capsule membrane is 100:1 to 100:100.

## Description

### TECHNICAL FIELD

The present invention relates to a new latent curing agent for an epoxy resin composition and more specifically the present invention relates to a latent curing agent to provide both superior low temperature hardening property and storage stability, along with easy compounding with an epoxy resin and good cured material characteristics, and an epoxy resin composition using the same.

### BACKGROUND ART

An epoxy resin is utilized in wide applications such as coating material, insulating material for electric and electronics parts, adhesives, and the like because cured material thereof has superior mechanical characteristics, electrical characteristics, thermal characteristics, chemical resistance, adhesiveness, etc. An epoxy resin composition presently used is so to speak a two-pot type to be used by mixing 2 liquids of an epoxy resin and a curing agent just before use.

A two-pot type epoxy resin can be hardened at room temperature, however, an epoxy resin and a curing agent need to be stored separately, and weighing and mixing them responsive to necessary time, which require complicated storage and handling.

Further more, service time is limited, which inhibits large quantity of mixing beforehand, increase compounding frequency and inevitably lowers efficiency. To solve such problems of compounds of a two-pot type epoxy resin composition, several one-pot type epoxy resin compositions have been proposed. For example, such an epoxy resin compounded with a latent curing agent, for example, dicyandiamide, a BF₃-amine complex, an amine salt, a modified imidazole compound, etc.

However, among these latent curing agents, those with superior storage stability have high hardening temperature, while those with low hardening temperature have inferior storage stability, for example, storage at -20°C, and the like is required. For example, dicyandiamide provides storage stability of a compound not shorter than 6 months at room temperature storage but requires hardening temperature not lower than 170°C. By combined use with a hardening promoter to lower the hardening temperature, hardening at, for example, 130°C can be attained, however, storage stability at room temperature is insufficient and thus storage at low temperature is essentially required. Therefore, a curing agent providing a composition superior in both low temperature hardening property and storage stability has strongly been required.

In response to such needs, so to speak a micro capsule type curing agent obtained by covering a core of an amine type curing agent with a specific shell has been proposed, which has provided certain level of result on compatibility of low temperature hardening property and storage stability. For example, in JP-A-1-70523 is disclosed a masterbatch type curing agent for a one-pot type epoxy resin composition, consisting of an epoxy resin and a curing agent composed of a specific amine type curing agent core and a shell of a reaction product between the above-described amine compound and an epoxy resin.

However, to respond to improvement of circuit high densification or long term continued reliability required recently, in particular, in electronics equipment field, or to use material with low heat resistance as measures to reduce weight of mobile equipment or to significantly improve productivity, still further improvement of hardening property without impairing storage stability has been strongly required for a one-pot epoxy resin composition used as conjunction material, which is difficult to attain based on conventional technology.

### DISCLOSURE OF THE INVENTION

It is an object of the present invention to provide a latent curing agent to obtain a one-pot epoxy resin composition having both fast hardening property and storage stability and to provide anisotropic conductive material, conductive adhesive material, insulating adhesive material, encapsulant, and the like to obtain high storage stability and high junction reliability, adhesive strength and high encapsulation ability even under low temperature or short time hardening conditions.

The present inventors have extensively studied to solve the above-described problems and found that a capsule type curing agent obtained by a specific amine type curing agent as a core, which is covered by a specific capsule membrane with specific amount ratio to the core, can satisfy the above objectives and thus completed the present invention based on this knowledge.

That is the present invention includes the following aspects:
1) A capsule type curing agent which comprises a core containing an amine type curing agent (A) and a capsule and a membrane covering said core, wherein said capsule membrane has a bonding group (x) absorbing infrared ray of a wave-number of 1630 to 1680 cm⁻¹ and/or a bonding group (y) absorbing infrared ray of a wave-number of 1680 to 1725 cm⁻¹, and contains cured material of an epoxy resin by the amine type curing agent (A) as a curing agent, and weight ratio of the core and the capsule membrane is 100:1 to 100:100.
2) The capsule type curing agent according to the above aspect 1), wherein in ¹³C-NMR spectrum of the capsule membrane, ratio of a largest peak height between 37 to 47 ppm to a largest peak height between 47 to 57 is not lower than 3.
3) The capsule type curing agent according to the above aspect 1) or 2), wherein melt viscosity of the amine type curing agent (A) at 160°C is not higher than 10 Pa·s.
4) The capsule type curing agent according to any one of the above aspects 1) to 3), wherein the amine type curing agent (A) has at least one tertiary amino group in one molecule thereof.
5) The capsule type curing agent according to any one of the above aspects 1) to 4), wherein total amount of chlorines in the amine type curing agent (A) is not more than 400 ppm.
6) The capsule type curing agent according to any one of the above aspects 1) to 5), wherein the amine type curing agent (A) is a reaction product between an epoxy resin (B) having total amount of chlorines of not more than 400 ppm and an amine compound (C).
7) The capsule type curing agent according to any one of the above aspects 1) to 6), wherein total amount of chlorines in an epoxy resin (D) is not more than 400 ppm.
8) The capsule type curing agent according to any one of the above aspects 1) to 7), wherein the capsule membrane is comprised of a shell of a reaction product between the amine type curing agent (A) and the epoxy resin (D) and an intermediate layer having the bonding group (x) and/or the bonding group (y).
9) A masterbatch type curing agent comprising 100 parts by weight of the capsule type curing agent according to any one of the above aspects 1) to 8) and 10 to 50,000 parts by weight of an epoxy resin (E).
10) An epoxy resin composition comprising, as main components, 100 parts by weight of an epoxy resin (F) and the capsule type curing agent according to any one of the above aspects 1) to 8) or the masterbatch type curing agent according to the above aspect 9) or a mixture thereof in such an amount as the total amount of the capsule type curing agents is 0.1 to 100 parts by weight.
11) An epoxy resin composition comprising, as main components, 100 parts by weight of the epoxy resin (F), 1 to 200 parts by weight of at least one kind of a curing agent (G) selected from a group consisting of acid anhydrides, phenols, hydrazides and guanidines, and the capsule type curing agent according to any one of the above aspects 1) to 8) or the masterbatch type curing agent according to the above aspect 9) or a mixture thereof in such an amount as the total amount of the capsule type curing agent is 0.1 to 100 parts by weight.
12) An anisotropic conductive material containing the epoxy resin composition according to the above aspect 10) or 11).
13) A conductive adhesive material containing the epoxy resin composition according to the above aspect 10) or 11).
14) An insulating adhesive material containing the epoxy resin composition according to the above aspect 10) or 11).
15) An encapsulant containing the epoxy resin composition according to the above aspect 10) or 11).

### MODE FOR CARRYING OUT THE INVENTION

The present invention is explained in more detail below.

In a capsule type curing agent of the present invention, a core part containing the amine type curing agent (A) is covered by a capsule membrane.

The amine type curing agent (A) used in the present invention is preferably an amine type curing agent for an epoxy resin, including a low molecular weight amine compound and an amine adduct. They can be used in combination.

The low molecular weight amine compound includes a low molecular weight compound having a primary-, secondary- and/or tertiary amino group.

Low molecular weight compounds containing a primary amino group include primary amines such as ethylenediamine, diethylenetriamine, triethylenetetramine, tetraethylenepentamine, hexamethylenediamine, isophorone diamine, bis(4-amino-3-methylcyclohexyl)methane, diaminodicyclohexylmethane, m-xylenediamine, diaminodiphenylmethane, diaminodiphenylsulfone, m-phenylenediamine, etc.; guanidines such as dicyandiamide, methylguanidine, ethylguanidine, propylguanidine, butylguanidine, dimethylguanidine, trimethylguanidine, phenylguanidine, diphenylguanidine, toluylguanidine, etc.; acid hydrazides such as succinic acid dihydrazide, adipic acid dihydrazide, phthalic acid dihydrazide, isophthalic acid dihydrazide, terephthalic acid dihydrazide, p-hydroxybenzoic acid hydrazide, salicylic acid hydrazide, phenylaminopropionic acid hydrazide, maleic acid dihydrazide, etc.

Low molecular weight compounds containing a secondary amino group include piperidine, pyrrolidine, diphenylamine, 2-methylimidazole, 2-ethyl-4-methylimidazole, etc.

Low molecular weight compounds containing a tertiary amino group include imidazoles such as 1-cyanoethyl-2-undecylimidazole-trimellitate, imidazolylsuccinic acid, 2-methylimidazole-succinic acid, 2-ethylimidazole-succinic acid, 1-cyanoethyl-2-methylimidazole, 1-cyanoethyl-2-undecylimidazole, 1-cyanoethyl-2-phenylimidazole, etc.; benzyldimethylamine, triethanolamine, 2,4,6-tris(dimethylaminomethyl)phenol, N,N'-dimethylpiperazine, triethylenediamine, 1,8-diazabicyclo[5.4.0]undec-7-ene, 1,5-diazabicyclo[4.3.0]non-5-ene, pyridine, picoline, etc.

The amine adduct is a compound with an amino group obtained by a reaction between at least one kind of a compound selected from a group consisting of a carboxylic acid compound, a sulfonic acid compound, an isocyanate compound, a urea compound and the epoxy compound (B), and the amine compound (C).

A carboxylic acid compound, a sulfonic acid compound, an isocyanate compound, a urea compound and the epoxy compound (B), used as raw material of the amine adduct are shown below.

The carboxylic acid compound includes, for example, succinic acid, adipic acid, sebacic acid, phthalic acid, dimer acid, etc.

The sulfonic acid compound includes, for example, ethanesulfonic acid, p-toluenesulfonic acid, etc.

The isocyanate compound includes, for example, an aliphatic diisocyanates, an alicyclic diisocyanate, an aromatic diisocyanate, an aliphatic triisocyanate, a polyisocyanate, etc.

The aliphatic diisocyanates include ethylenediisocyanate, propylenediisocyanate, butylenediisocyanate, hexamethylenediisocyanate, trimethylhexamethylenediisocyanate, etc.

The alicyclic diisocyanates include isophorone diisocyanate, 4,4'-dicyclohexylmethane diisocyanate, norbornane diisocyanate, 1,4-diisocyanatocyclohexane, 1,3-bis(isocyanatomethyl)cyclohexane, 1,3-bis(2-isocyanatopropyl-2yl)-cyclohexane, etc.

The aromatic diisocyanates include tolylenediisocyanate, 4,4'-diphenylmethane diisocyanate, xylenediisocyanate, 1,5-naphthalene diisocyanate, etc.

The aliphatic triisocyanates include 1,3,6-tri(isocyanatomethyl)hexane, 2-isocyanatoethyl 2,6-diisocyanatohexanoate, etc.

The polyisocyanates include polymethylene polyphenylene polyisocyanate or polyisocyanates derived from the above-described diisocyanate compounds.

The polyisocyanates derived from the above-described diisocyanate compounds include an isocyanurate type polyisocyanate, a biuret type polyisocyanate, a urethane type polyisocyanate, an allophanate type polyisocyanate, a carbodiimide type polyisocyanate, etc.

The urea compounds include, for example, urea, methylurea, dimethylurea, ethylurea, tert-butylurea, etc.

As the epoxy resin (B), any of a mono epoxy compound and a polyvalent epoxy compound, or a mixture thereof is used.

The monoepoxy compounds include butyl glycidyl ether, hexyl glycidyl ether, phenyl glycidyl ether, allyl glycidyl ether, p-tert-butylphenyl glycidyl ether, ethylene oxide, propylene oxide, p-xylyl glycidyl ether, glycidyl acetate, glycidyl butyrate, glycidyl hexanoate, glycidyl benzoate, etc.

The polyvalent epoxy compounds include, for example, glycidylated bisphenols-type epoxy resin derived from such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A, tetrachlorobisphenol A, tetrafluorobisphenol A, etc.; glycidylated polyvalent phenols-type epoxy resin including
glycidylated other dihydric phenols type epoxy resin derived from such as biphenol, dihydroxynaphthalene, 9,9-bis(4-hydroxyphenyl)fluorene, etc.,
glycidylated triphenols-type epoxy resin derived from such as 1,1,1-tris(4-hydroxyphenyl)methane, 4,4-(1-(4-(1-(4-hydroxyphenyl)-1-methylethyl)phenyl)ethylidene)bisphenol, etc.,
glycidylated tetraphenols-type epoxy resin derived from such as 1,1,2,2-tetrakis(4-hydroxyphenyl)ethane, etc., glycidylated novolacs-type epoxy resin derived from such as phenol novolac, cresol novolac, bisphenol A novolac, brominated phenol novolac, brominated bisphenol A novolac, etc.;
glycidylated polyvalent alcohols-type, that is, aliphatic ether-type epoxy resin derived from such as glycerine, polyethyleneglycol, etc.;
glycidylated hydroxycarboxylic acid-type, that is ether-ester-type epoxy resin derived from such as p-hydroxybenzoic acid, β-hydroxynaphthoic acid, etc.;
glycidylated polycarboxylic acid-type, that is ester-type epoxy resin derived from such as phthalic acid, terephthalic acid, etc.;
glycidylated amine-type epoxy resin derived from such as glycidylated amine compounds such as 4,4'-diaminodiphenylmethane, m-aminophenol or triglycidyl isocyanurate, etc.;
alicyclic epoxides such as 3,4-epoxycyclohexylmethyl-3',4'-epoxycyclohexanecarboxylate, etc.

Among the carboxylic acid compound, the sulfonic acid compound, the isocynate compound, the urea compound or the epoxy resin (B) used as raw material of the amine adduct, the epoxy resin (B) is preferable due to having superior hardening property and storage stability.

As the epoxy resin (B), a polyvalent epoxy compound is preferable due to enable to enhance storage stability of an epoxy resin composition. As the polyvalent epoxy compound, a glycidyl type epoxy resin is preferable due to providing far higher productivity of the amine adduct, and a glycidylated polyvalent phenols-type epoxy resin is more preferable due to providing cured material with superior adhesiveness and heat resistance, and bisphenol type epoxy resin is further preferable. A glycidylated bisphenol A-type epoxy resin and a glycidylated bisphenol F-type epoxy resin are still more preferable. A glycidylated bisphenol A-type epoxy resin is far more preferable.

Total chlorine amount of the epoxy resin (B) is preferably not higher than 400 ppm, due to compatibility of superior hardening property and storage stability. It is more preferably not higher than 300 ppm, more preferably not higher than 200 ppm, more preferably not higher than 180 ppm, more preferably not higher than 171 ppm, more preferably not higher than 100 ppm, more preferably not higher than 80 ppm, and further preferably not higher than 50 ppm. Total chlorine amount is preferably not lower than 0.01 ppm, due to easy control of shell forming reaction, more preferably not lower than 0.02 ppm, more preferably not lower than 0.05 ppm, more preferably not lower than 0.1 ppm, more preferably not lower than 0.2 ppm and further preferably not lower than 0.5 ppm. For example, preferable range of total chlorine amount is not lower than 0.1 ppm and not higher than 200 ppm, more preferably not lower than 0.2 ppm and not higher than 80 ppm and more preferably not lower than 0.5 ppm and not higher than 50 ppm.

In the present invention, "total chlorine amount" means total amount of organic chlorines and inorganic chlorines contained in a compound and weight based value for the compound.

Among total chlorines, chlorine contained in a 1,2-chlorohydrin group is generally called as "hydrolyzable chlorine" and amount of "hydrolyzable chlorine" in the epoxy resin (B) used in the present invention is preferably not higher than 50 ppm, more preferably 0.01 to 20 ppm and further preferably 0.05 to 10 ppm. It is preferable for amount of "hydrolyzable chlorine" to be not higher than 50 ppm due to being advantageous to compatibility of hardening property and storage stability, along with showing superior electric characteristics.

In the present invention, when amount of total chlorines in an epoxy resin is to be decreased, such a method is exemplified: a method for carrying out a dechlorination reaction using a basic catalyst in an aprotic solvent, followed by purification of an epoxy resin by washing with water; or a method for carrying out a dechlorination reaction using a metal amide compound such as a metal salt of bis(trialkylsilyl)amide, and the like as a catalyst, followed by purification of an epoxy resin by washing with water.

As the amine compound (C) for raw material of an amine adduct includes a compound having at least one primary amino group and/or secondary amino group but not having a tertiary amino group, and a compound having at least one tertiary amino group and at least one activated hydrogen group.

Compounds containing at least one primary amino group and/or secondary amino group but not containing tert-amino group include, for example, primary amines not containing tert-amino group, such as methylamine, ethylamine, propylamine, butylamine, ethylenediamine, propylenediamine, hexamethylenediamine, diethylenetriamine, triethylenetetramine, ethanolamine, propanolamine, cyclohexylamine, isophoronediamine, aniline, toluidine, diaminodiphenylmethane, diaminodiphenylsulfone, etc.; and secondary amines not containing tert-amino group, such as dimethylamine, diethylamine, dipropylamine, dibutylamine, dipentylamine, dihexylamine, dimethanolamine, diethanolamine, dipropanolamine, dicyclohexylamine, piperidine, piperidone, diphenylamine, phenylmethylamine, phenylethylamine, etc.

In a compound having at least one tertiary amino group and at least one activated hydrogen group, examples of the activated hydrogen group include a primary amino group, a secondary amino group, a hydroxyl group, a thiol group, a carboxyl group and a hydrazide group.

A compound having at least one tertiary amino group and at least one activated hydrogen group includes, for example, amino alcohols such as 2-dimethylaminoethanol, 1-methyl-2-dimethylaminoethanol, 1-phenoxymethyl-2-dimethylaminoethanol, 2-diethylaminoethanol, 1-butoxymethyl-2-dimethylaminoethanol, methyldiethanolamine, triethanolamine, N-β-hydroxyethylmorpholine, etc.; amino phenols such as 2-(dimethylaminomethyl)phenol, 2,4,6-tris(dimethylaminomethyl)phenol, etc.; imidazoles such as 2-methylimidazole, 2-ethyl-4-methylimidazole, 2-undecylimidazole, 2-heptadecylimidazole, 2-phenylimidazole, 1-aminoethyl-2-methylimidazole, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, 1-(2-hydroxy-3-butoxypropyl)-2-ethyl-4-methylimidazole, etc.; imidazolines such as 1-(2-hydroxy-3-phenoxypropyl)-2-phenylimidazoline, 1-(2-hydroxy-3-butoxypropyl)-2-methylimidazoline, 2-methylimidazoline, 2,4-dimethylimidazoline, 2-ethylimidazoline, 2-ethyl-4-methylimidazoline, 2-benzylimidazoline, 2-phenylimidazoline, 2-(o-tolyl)imidazoline, tetramethylene-bisimidazoline, 1,1,3-trimethyl-1,4-tetramethylene-bisimidazoline, 1,3,3-trimethyl-1,4-tetramethylene-bisimidazoline, 1,1,3-trimethyl-1,4-tetramethylene-bis4-methylimidazoline, 1,3,3-trimethyl-1,4-tetramethylene-bis4-methylimidazoline, 1,2-phenylene-bisimidazoline, 1,3-phenylene-bisimidazoline, 1,4-phenylene-bisimidazoline, 1,4-phenylene-bis4-methylimidazoline, etc.; tert-amino amines such as dimethylaminopropylamine, diethylaminopropylamine, dipropylaminopropylamine, dibutylaminopropylamine, dimethylaminoethylamine, diethylaminoethylamine, dipropylaminoethylamine, dibutylaminoethylamine, N-methylpiperazine, N-aminoethylpiperazine, diethylamminoethylpiperazine, etc.; aminomeracaptans such as 2-dimethylaminoethanethiol, 2-mercaptobenzoimidazole, 2-mercaptobenzothiazole, 2-mercaptopyridine, 4-mercaptopyridine, etc.; amino carboxylic acids such as N,N-dimethylaminobenzoic acid, N,N-dimethyl glycine, nicotinic acid, isonicotinic acid, picolinic acid, etc.; and amino hydrazides such as N,N-dimethylglycin hydrazide, nicotinic acid hydrazide, isonicotinic acid hydrazide.

A reaction product between a compound having at least one primary amino group and/or secondary amino group but not having a tertiary amino group, and the epoxy resin (B) can also be used as a compound having at least one tertiary amino group and at least one activated hydrogen group

As the amine compound (C), a compound having at least one tertiary amino group and at least one activated hydrogen group is preferable due to superior balance between storage stability and hardening property, and a reaction product between a compound having at least one primary amino group and/or secondary amino group but not having a tertiary amino group, and the epoxy resin (B) and imidazoles are further preferable. Imidazoles are further more preferable and 2-methylimidazole and 2-ethyl-4-methylimidazole are still further preferable.

The amine adduct used in the present invention can be obtained by a reaction between 1 to 5 moles of the amine compound (C) and 1 to 5 moles of the epoxy resin (B) in the presence of a solvent, if necessary, for example, at 50 to 250°C for 0.1 to 10 hours and removing unreacted amine compound (C) and a solvent, if necessary.

A solvent used here is not especially limited, however, includes, for example, hydrocarbons such as benzene, toluene, xylene, cyclohexane, mineral sprit, naphtha, etc.; ketones such as acetone, methylethyl ketone, methylisobutyl ketone, etc.; esters such as ethyl acetate, n-butyl acetate, propyleneglycol monomethylether acetate, etc.; alcohols such as methanol, isopropanol, n-butanol, butylcellosolve, butyl carbitol, etc.; water, etc., which may be used in combination.

When the epoxy resin (B) with total chlorine amount not higher than 400 ppm, local reaction is easily proceeds, therefore, to suppress generation of gel-like substance or increase in melt viscosity of an amine adduct, it is necessary to take measures, for example, to slowly add the epoxy resin (B), diluted with a solvent, in drop-wise over several hours to the amine adduct compound(C) diluted with a solvent.

As the amine type curing agent (A) used in the present invention, an amine adduct is preferable due to high storage stability. Further more, as the amine type curing agent (A), a compound having at least one tertiary amino group in a molecule is preferable due to providing cured material having high mechanical characteristics and electrical characteristics. A compound having at least one tertiary amino group in a molecule but not having either a primary amino group or secondary amino group is more preferable and a compound not having all of a primary amino group and secondary amino group is further preferable, because excessive increase in viscosity of an epoxy resin composition can be suppressed.

Total chlorine amount in the amine type curing agent (A) is not higher than 400 ppm, preferably not higher than 300 ppm, more preferably not higher than 180 ppm, further preferably not higher than 120 ppm, further more preferably not higher than 80 ppm and still further more preferably not higher than 50 ppm. When total chlorine amount in the amine type curing agent (A) used in the present invention is not higher than 400 ppm, formation of compact shell without crosslink defect is possible and compatibility of hardening property and storage stability is possible. Whereas, total chlorine amount in the amine type curing agent (A) is preferably not lower than 0.01 ppm and more preferably not lower than 0.05 ppm. When total chlorine amount is not lower than 0.01 ppm, control of shell formation becomes easy.

Melt viscosity at 160°C of the amine type curing agent (A) is preferably not higher than 10 Pa·s, further preferably not higher than 8 Pa·s, more preferably not higher than 5 Pa·s and still further preferably not higher than 3 Pa·s. When melt viscosity at 160°C of the amine type curing agent is not higher than 10 Pa·s, an epoxy resin composition with superior hardening property, in particular, at high temperature and in short time can be obtained. While, melt viscosity at 160°C of the amine type curing agent is preferably not lower than 0.1 Pa·s, because an epoxy resin composition with high storage stability can be obtained.

Shape of the amine type curing agent (A) includes liquid-like, bulk-like, granule-like, powder-like, and the like and is preferably granule-like and powder-like and further preferably powder-like. Powder size in the present invention is not especially limited, however, is preferably, as average particle diameter, 0.1 to 50 µm and further preferably average particle diameter of 0.5 to 10 µm. Particle diameter of not larger than 50 µm can provide uniform cured material. Particle diameter in the present invention means Stokes diameter measured by a light scattering method and average particle diameter indicates median diameter. Particle shape is not especially limited and may be any of spherical and irregular one, however, spherical shape is preferable to reduce viscosity of a masterbatch or an epoxy resin composition. "Spherical shape" here includes not only true spherical shape but also irregular shape with round corners.

A capsule type curing agent of the present invention is a curing agent whose core is covered with a capsule membrane, wherein the capsule membrane contains the bonding group (x) absorbing infrared ray of wave-number of 1630 to 1680 cm⁻¹ and/or the bonding group (y) absorbing infrared ray of wave-number of 1680 to 1725 cm⁻¹, and cured material by the amine type curing agent (A) as a curing agent. The capsule membrane may be composed of a shell containing a reaction product between the amine type curing agent (A) and the epoxy resin (D), and an intermediate layer having the bonding group (x) and/or the bonding group (y). In this case, the capsule membrane may be composed of the intermediate layer with the bonding group (x) and/or the bonding group (y) present at the core surface layer, and a shell, that is cured material between the amine type curing agent (A) and the epoxy resin (D), and the intermediate layer and the shell may not be clearly separated. The capsule membrane preferably has both the bonding group (x) and the bonding group (y).

The bonding group (x) and the bonding group (y) can be measured using Fourier transformed infrared spectroscopy (called FT-IR). Presence of the bonding group (x) and the bonding group (y) at least at the surface of the amine type curing agent (A) can be measured using micro-FT-IR.

A particularly useful bond among the bonding group (x) includes a urea bond. A particularly useful bond among the bonding group (y) includes a biuret bond.

These urea bond and biuret bond can be formed by a reaction between an isocyanate compound and water or an amine compound having 1 or more amino groups in a molecule. An isocyanate compound used to form a urea bond as a representative bond of the bonding group (x) and a biuret bond as a representative bond of the bonding group (y) may be a compound having 1 or more isocyanate groups in a molecule, preferably 2 or more isocyanate groups in a molecule.

Typical isocyanate compounds include aliphatic diisocyanates, alicyclic diisocyanates, aromatic diisocyanates, low molecular weight triisocyanates and polyisocyanates. Examples of the aliphatic diisocyanates include ethylenediisocyanate, propylenediisocyanate, butylenediisocyanate, hexamethylenediisocyanate, trimethylhexamethylenediisocyanate, etc. Examples of alicyclic diisocyanates include isophorone diisocyanate, 4,4'-dicyclohexylmethane diisocyanate, norbornane diisocyanate, 1,4-diisocyanatocyclohexane, 1,3-bis(isocyanatomethyl)cyclohexane, 1,3-bis(2-isocyanatopropyl-2yl)-cyclohexane, etc. Examples of the aromatic diisocyanates include tolylenediisocyanate, 4,4'-diphenylmethane diisocyanate, xylenediisocyanate, 1,5-naphthalene diisocyanate, etc. Examples of the low molecular weight triisocyanates include aliphatic triisocyanate compounds such as 1,6,11-undecanetriisocyanate, 1,8-diisocyanato-4-isocyanatomethyloctane, 1,3,6-hexamethylenetriisocyanate, 2,6-diisocyanatohexanoic acid 2-isocyanatoethyl ester, 2,6-diisocyanatohexanoic acid 1-methyl-2-isocyanatoethyl ester, etc.; alicyclic triisocyanate compounds such as tricyclohexylmethane triisocyanate, bicycloheptane triisocyanate, etc.; and aromatic triisocyanate compounds such as triphenylmethane triisocyanate, tris(isocyanatophenyl) thiophosphate, etc. Examples of the polyisocyanates include polymethylene polyphenylene polyisocyanate, polyisocyanates derived from the above-described diisocyanates or low molecular weight triisocyanates. Polyisocyanates derived from the above-described diisocyanates or triisocyanates include isocyanurate-type polyisocyanates, biuret-type polyisocyanates, urethane-type polyisocyanates, allophanate-type polyisocyanates, carbodiimide-type polyisocyanates, etc.

As amine compounds having 1 or more primary amino group in a molecule to form a urea bond or a biuret bond as a representative bond of the bonding group (x) and the bonding group (y), aliphatic amines, alicyclic amines and aromatic amines can be used. Examples of the aliphatic amines include alkylamines such as methylamine, ethylamine, propylamine, butylamine, etc.; alkylene diamines such as ethylenediamine, propylenediamine, butylenediamine, hexamethylenediamine, etc.; polyalkylenepolyamines such as diethylenetriamine, triethylenetetramine, tetraethylenepentamine, etc. Examples of the alicyclic amines include cyclopropylamine, cyclobutylamine, cyclopentylamine, cyclohexylamine, isophorone diamine, etc. Examples of the aromatic amines include aniline, toluidine, benzylamine, naphthylamine, diaminodiphenylamine, diaminodiphenylsulfone, etc.

In the capsule membrane, the bonding group (x) and the bonding group (y) each has concentration range of 1 to 1000 meq/kg. The concentration here is value relative to the amine type curing agent (A).

Concentration of the bonding group (x) not lower than 1 meq/kg is advantageous to obtain a capsule type curing agent having high resistance to mechanical shear force. While, the concentration not higher than 1000 meq/kg is advantageous to obtain high hardening property. Further preferable concentration range of the bonding group (x) is 10 to 300 meq/kg.

Concentration of the bonding group (y) not lower than 1 meq/kg is advantageous to obtain a capsule type curing agent having high resistance to mechanical shear force. While, the concentration not higher than 1000 meq/kg is advantageous to obtain high hardening property. Further preferable concentration range of the bonding group (y) is 10 to 200 meq/kg.

The capsule membrane composing the capsule type curing agent of the present invention preferably has, in addition to the bonding group (x) and the bonding group (y), the bonding group (z) which absorbs infrared ray of wave number of 1730 to 1755 cm⁻¹. A particularly useful one among the bonding group (z) is a urethane group. The urethane group is formed by a reaction between an isocyanate compound and a compound having one or more hydroxyl group in a molecule. As an isocyanate compound here, an isocyanate compound used to form a urea bond or a biuret bond can be used. As a compound having one or more hydroxyl group in a molecule used to form a urethane bond as a representative of the bonding group (z) includes, alcohol compounds such as aliphatic saturated alcohols, aliphatic unsaturated alcohols, alicyclic alcohols and aromatic alcohols, and phenol compounds can be used. Aliphatic alcohols include monohydric alcohols such as methyl alcohol, propyl alcohol, butyl alcohol, amyl alcohol, hexyl alcohol, heptyl alcohol, octyl alcohol, nonyl alcohol, decyl alcohol, undecyl alcohol, lauryl alcohol, dodecyl alcohol, stearyl alcohol, icosyl alcohol, etc.; ethyleneglycol monoalkyl ethers such as ethyleneglycol monomethyl ethers, ethyleneglycol monoethyl ethers, ethyleneglycol monobutyl ethers, ethyleneglycol monohexyl ethers, etc.; dihydric alcohols such as ethyleneglycol, polyethyleneglycol, propyleneglycol, polypropyleneglycol, 1,3-butanediol, neopentylglycol, etc.; trihydric alcohols such as glycerine, trimethylolpropane, etc.; tetrahydric alcohols such as pentaerythritol, etc. Aliphatic unsaturated alcohols include allyl alcohol, crotyl alcohol, propargyl alcohol, etc. Alicyclic alcohols include cyclopentanol, cyclohexanol, cyclohexanedimethanol, etc. Aromatic monohydric alcohols include mono alcohols such as benzyl alcohol, cinnamyl alcohol, etc. These alcohols may be any of primary-, secondary- or tertiary alcohols. A compound having one or more secondary hydroxyl group in a molecule, obtained by a reaction between a compound having one or more epoxy group in a molecule and a compound having one or more hydroxyl group, a carboxyl group, a primary amino group or secondary amino group and a mercapt group in a molecule can also be used as an alcohol compound. A phenol compound includes monohydric phenols such as phenol, cresol, xylenol, carvacrol, thymol, naphthol, etc.; dihydric phenols such as catecol, resorcin, hydroquinone, bisphenol A, bisphenol F, etc.; trihydric phenol such as pyrogallol, phloroglucin, etc. A preferable compound of them having one or more hydroxyl group in a molecule is an alcohol compound or a phenol compound having dihydric or further hydroxyl group.

Preferable concentration range of the bonding group (z) in the capsule membrane is 1 to 200 meq/kg. The concentration here is value relative to the amine type curing agent (A). Concentration of the bonding group (z) not lower than 1 meq/lg is advantageous to form a shell with high resistance to mechanical shear force and the concentration not lower than 200 meq/lg is advantageous to obtain superior hardening property. Further preferable concentration range of the bonding group (z) is 5 to 100meq/g.

Quantitative measurement of concentrations of the bonding group (x), the bonding group (y) and the bonding group (z) can be carried out by a method disclosed in JP-A-7-5708.

In the present invention, a method for covering a core with an intermediate layer includes; a method for dissolving the intermediate layer, followed by decreasing solubility of the intermediate layer in a medium dispersed with the core to deposit at core surface; and a method for carrying out a reaction to form the intermediate layer in a medium dispersed with the core to deposit the intermediate layer at core surface or form the intermediate layer there using core surface as reaction field. The latter method is preferable because reaction and covering can be carried out simultaneously.

A dispersion medium here includes a solvent, a plasticizer, etc. The epoxy resin (D) may be used as a dispersion medium.

Solvents include, for example, hydrocarbons such as benzene, toluene, xylene, cyclohexane, mineral sprit, naphtha, etc.; ketones such as acetone, methylethyl ketone, methylisobutyl ketone, etc.; esters such as ethyl acetate, n-butyl acetate, propyleneglycol monomethylether acetate (or 2-acetoxy-1-methoxypropane), etc.; alcohols such as methanol, isopropanol, n-butanol, butylcellosolve, butyl carbitol, etc.; water, etc. Plasticizers include phthalic acid diesters such as dibutyl phthalate, di(2-ethylhexyl) phthalate, etc.; aliphatic dibasic acid diesters such as di(2-ethylhexyl) adipate, etc.; phosphoric acid triesters such as tricresyl phosphate, etc.; glycol-esters such as polyethyleneglycol ester, etc.

The epoxy resin (D) used in the present invention includes, for example, glycidylated bisphenols-type epoxy resin derived from such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A, tetrachlorobisphenol A, tetrafluorobisphenol A, etc.; glycidylated polyvalent phenols-type epoxy resin including glycidylated other dihydric phenols type epoxy resin derived from such as biphenol, dihydroxynaphthalene, 9,9-bis(4-hydroxyphenyl)fluorene, etc.,
glycidylated triphenols-type epoxy resin derived from such as 1,1,1-tris(4-hydroxyphenyl)methane, 4,4-(1-(4-(1-(4-hydroxyphenyl)-1-methylethyl)phenyl)ethylidene)bisphenol, etc.,
glycidylated tetraphenols-type epoxy resin derived from such as 1,1,2,2-tetrakis(4-hydroxyphenyl)ethane, etc., glycidylated novolacs-type epoxy resin derived from such as phenol novolac, cresol novolac, bisphenol A novolac, brominated phenol novolac, brominated bisphenol A novolac, etc.;
glycidylated polyvalent alcohols-type, that is, aliphatic ether-type epoxy resin derived from such as glycerine, polyethyleneglycol, etc.;
glycidylated hydroxycarboxylic acid-type, that is ether-ester-type epoxy resin derived from such as p-hydroxybenzoic acid, β-hydroxynaphthoic acid, etc.;
glycidylated polycarboxylic acid-type, that is ester-type epoxy resin derived from such as phthalic acid, terephthalic acid, etc.;
glycidylated amine-type epoxy resin derived from such as glycidylated amine compounds such as 4,4'-diaminodiphenylmethane, m-aminophenol or triglycidyl isocyanurate, etc.;
alicyclic epoxides such as 3,4-epoxycyclohexylmethyl-3',4'-epoxycyclohexanecarboxylate, etc.

As the epoxy resin (D), a glycidyl type epoxy resin is preferable due to providing an epoxy composition with high storage stability, and more preferable one is glycidylated polyvalent phenols-type epoxy resin due to providing cured material with superior adhesiveness or heat resistance, and further preferable is a bisphenol type epoxy resin. Glycidylated bisphenol A-type epoxy resin and glycidylated bisphenol F-type epoxy resin are further preferable. Glycidylated bisphenol A-type epoxy resin is still further preferable.

Total chlorine amount in the epoxy resin (D) is preferably not higher than 400 ppm, due to being advantageous to form a compact shell without crosslink defect and to compatibility of hardening property and storage stability, more preferably not higher than 300 ppm, more preferably not higher than 200 ppm, more preferably not higher than 180 ppm, more preferably not higher than 171 ppm, more preferably not higher than 100 ppm, more preferably not higher than 80 ppm and further preferably not higher than 50 ppm. To make control easy for shell formation, total chlorine amount is preferably not lower than 0.01 ppm, more preferably not lower than 0.02 ppm, more preferably not lower than 0.05 ppm, more preferably not lower than 0.1 ppm more preferably not lower than 0.2 ppm and further preferably not lower than 0.5 ppm. For example, preferable range of total chlorine amount is not lower than 0.1 ppm and not higher than 200 ppm, more preferable range is not lower than 0.2 ppm and not higher than 80 ppm and more preferable range is not lower than 0.5 ppm and not higher than 50 ppm.

Among total chlorines, chlorine contained in a 1,2-chlorohydrine group is generally called as "hydrolyzable chlorine" and amount of "hydrolyzable chlorine" in the epoxy resin (D) used in the present invention is preferably not higher than 50 ppm, more preferably 0.01 to 20 ppm and further preferably 0.05 to 10 ppm. It is preferable for "hydrolyzable chlorine" to be not higher than 50 ppm due to being advantageous to compatibility of hardening property and storage stability, along with superior electric characteristics.

These epoxy resins may be used alone or in combination.

The capsule type curing agent of the present invention contains the amine type curing agent (A) and the epoxy resin (D).

A reaction between the amine type curing agent (A) and the epoxy resin (D) is usually carried out at temperature range of -10°C to 150°C, preferably at 0°C to 100°C for 1 to 168 hours, preferably 2 to 72 hours and may be carried out in a dispersion medium. As the dispersion medium, a solvent and a plasticizer are exemplified. The epoxy resin (D) itself may be used as the dispersion medium.

An example the solvent includes, for example, hydrocarbons such as benzene, toluene, xylene, cyclohexane, mineral sprit, naphtha, etc.; ketones such as acetone, methylethyl ketone, methylisobutyl ketone, etc.; esters such as ethyl acetate, n-butyl acetate, propyleneglycol monomethylether acetate (or 2-acetoxy-1-methoxypropane), etc.; alcohols such as methanol, isopropanol, n-butanol, butylcellosolve, butyl carbitol, etc.; water, etc. Plasticizers include phthalic acid diesters such as dibutyl phthalate, di(2-ethylhexyl) phthalate, etc.; aliphatic dibasic acid diesters such as di(2-ethylhexyl) adipate, etc.; phosphoric acid triesters such as tricresyl phosphate, etc.; glycol-esters such as polyethyleneglycol ester, etc.

Weight ratio of the amine type curing agent (A) and the epoxy resin (D) to be reacted is not especially limited, however, is generally in the range of 1:0.001 to 1:1000, preferably in the range of 1:0.01 to 1:100.

The capsule membrane may be composed of a shell of a reaction product between the amine type curing agent (A) and the epoxy resin (D), and an intermediate layer having the bonding group (x) and/or the bonding group (y).

In this case, the shell may cover the core.

As for the shell, a method for covering the core includes; a method for dissolving the shell, followed by decreasing solubility of the shell in a dispersion medium dispersed with the core to deposit at core surface; and a method for carrying out a shell formation reaction in a dispersion medium dispersed with the core to deposit the shell at the surface of the amine type curing agent (A) or form the shell there using core surface as reaction field. The latter method is preferable because reaction and covering can be simultaneously carried out.

In the latter method, the amine type curing agent (A) may be the same amine type curing agent (A) used as the core or may be added separately.

As for the covering with the shell, the core may be covered with the intermediate layer beforehand. Shell can also be formed after completion of the intermediate layer formation or before or during the formation of the intermediate layer. The shell and the intermediate layer may be chemically bonded.

Thickness of the capsule membrane is preferably 5 to 1000 nm as average layer thickness.

The thickness not thinner than 5 nm can provide storage stability, while the thickness not thicker than 1000 nm can provide practical hardening property. The layer thickness here can be measured using TEM (Transmission Electron Microscope). Particularly preferable total thickness of the capsule membrane is 10 to 100 nm as average layer thickness.

Weight ratio between the core and the capsule membrane is 100:1 to 100:100. In this range, both hardening property and storage stability can be satisfied. Preferably, the range is 100:2 to 100:80, more preferably 100:5 to 100:60 and further preferably 100:10 to 100:50.

In ¹³C-NMR spectrum of the capsule membrane, ratio of height of the largest peak at 47 to 57 ppm (called peak 1 hereinafter)to height of the largest peak at 37 to 47 ppm (called peak 2 hereinafter) is preferably not smaller than 3 and not larger than 7, more preferably not smaller than 3.5 and not larger than 6.5, further preferably not smaller than 4 and not larger than 6. The height ratio between the peak 1 and the peak 2 of not smaller than 3 and not larger than 7, is advantageous to make both hardening property and storage stability satisfactory.

It is preferable for the capsule type curing agent of the present invention to be used as a masterbatch type curing agent to be explained next, because mixing with an epoxy resin becomes easy in obtaining an epoxy resin composition.

The masterbatch type curing agent of the present invention contains 100 parts by weight of the capsule type curing agent of the present invention and 10 to 50,000 parts by weight (preferably 20 to 20,000 parts by weight) of the epoxy resin (E). When the epoxy resin (E) is contained in not lower than 10 parts by weight, the masterbatch type curing agent with easy handling can be obtained, while when it is contained in not higher than 50,000 parts by weight, substantial performance as a curing agent can be exerted.

The epoxy resin (E) used in the present invention includes, for example, glycidylated bisphenols-type epoxy resin derived from such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A, tetrachlorobisphenol A, tetrafluorobisphenol A, etc.; glycidylated polyvalent phenols-type epoxy resin including
glycidylated other dihydric phenols type epoxy resin derived from such as biphenol, dihydroxynaphthalene, 9,9-bis(4-hydroxyphenyl)fluorene, etc.,
glycidylated triphenols-type epoxy resin derived from such as 1,1,1-tris(4-hydroxyphenyl)methane, 4,4-(1-(4-(1-(4-hydroxyphenyl)-1-methylethyl)phenyl)ethylidene)bisphenol, etc.,
glycidylated tetraphenols-type epoxy resin derived from such as 1,1,2,2-tetrakis(4-hydroxyphenyl)ethane, etc., glycidylated novolacs-type epoxy resin derived from such as phenol novolac, cresol novolac, bisphenol A novolac, brominated phenol novolac, brominated bisphenol A novolac, etc.;
glycidylated polyvalent alcohols-type, that is, aliphatic ether-type epoxy resin derived from such as glycerine, polyethyleneglycol, etc.;
glycidylated hydroxycarboxylic acid-type, that is ether-ester-type epoxy resin derived from such as p-hydroxybenzoic acid, β-hydroxynaphthoic acid, etc.;
glycidylated polycarboxylic acid-type, that is ester-type epoxy resin derived from such as phthalic acid, terephthalic acid, etc.;
glycidylated amine-type epoxy resin derived from such as glycidylated amine compounds such as 4,4'-diaminodiphenylmethane, m-aminophenol or triglycidyl isocyanurate, etc.;
alicyclic epoxides such as 3,4-epoxycyclohexylmethyl-3',4'-epoxycyclohexanecarboxylate, etc.

As the epoxy resin (E), a glycidyl type epoxy resin is preferable due to superior hardening property and more preferable is a glycidylated polyvalent phenols-type epoxy resin due to providing cured material with superior adhesiveness or heat resistance, and further preferable is a bisphenol type epoxy resin. Glycidylated bisphenol A-type epoxy resin and glycidylated bisphenol F-type epoxy resin are further preferable. Glycidylated bisphenol A-type epoxy resin is still further preferable.

An example of manufacturing method for the masterbatch type curing agent of the present invention includes; a method for dispersing the capsule type curing agent of the present invention manufactured in advance in the epoxy resin (E) using, for example, a three roll, and the like; a method for carrying out a formation reaction of the capsule type curing agent in the epoxy resin (E) to simultaneously obtain the capsule type curing agent and the masterbatch type curing agent. The latter method is preferable in view of high productivity. In the latter method, the epoxy resin (D) as it is corresponds to the epoxy resin (E). Other epoxy resin may further be added.

The masterbatch type curing agent of the present invention is preferably in liquid or paste state. More preferably, viscosity thereof at 25°C is not higher than 500,000 Pa-s, further preferably 1000 to 300,000 Pa-s and still more preferably 3000 to 200,000 Pa-s. It is preferable for the masterbatch type curing agent to have viscosity of not higher than 500,000 Pa-s because of providing high workability and reducing waste amount due to low sticking to a container.

The masterbatch type curing agent of the present invention contains the capsule type curing agent and the epoxy resin (E) of the present invention, however, it can contain other components within the range not to impair function thereof. Content of the other components is preferably lower than 30% by weight.

By mixing the capsule type curing agent of the present invention and/or the masterbatch type curing agent (hereinafter called the present a curing agent) into an epoxy resin (F), an epoxy resin composition can be obtained.

The epoxy resin (F) used in the epoxy resin composition of the present invention is any kind as long as it has not lower than 2 epoxy groups in average per molecule and includes, for example, glycidylated bisphenols-type epoxy resin derived from such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A, tetrachlorobisphenol A, tetrafluorobisphenol A, etc.; glycidylated polyvalent phenols-type epoxy resin including
glycidylated other dihydric phenols type epoxy resin derived from such as biphenol, dihydroxynaphthalene, 9,9-bis(4-hydroxyphenyl)fluorene, etc.,
glycidylated triphenols-type epoxy resin derived from such as 1,1,1-tris(4-hydroxyphenyl)methane, 4,4-(1-(4-(1-(4-hydroxyphenyl)-1-methylethyl)phenyl)ethylidene)bisphenol, etc.,
glycidylated tetraphenols-type epoxy resin derived from such as 1,1,2,2-tetrakis(4-hydroxyphenyl)ethane, etc., glycidylated novolacs-type epoxy resin derived from such as phenol novolac, cresol novolac, bisphenol A novolac, brominated phenol novolac, brominated bisphenol A novolac, etc.;
glycidylated polyvalent alcohols-type, that is, aliphatic ether-type epoxy resin derived from such as glycerine, polyethyleneglycol, etc.;
glycidylated hydroxycarboxylic acid-type, that is ether-ester-type epoxy resin derived from such as p-hydroxybenzoic acid, β-hydroxynaphthoic acid, etc.;
glycidylated polycarboxylic acid-type, that is ester-type epoxy resin derived from such as phthalic acid, terephthalic acid, etc.;
glycidylated amine-type epoxy resin derived from such as glycidylated amine compounds such as 4,4'-diaminodiphenylmethane, m-aminophenol or triglycidyl isocyanurate, etc.;
alicyclic epoxides such as 3,4-epoxycyclohexylmethyl-3',4'-epoxycyclohexanecarboxylate, etc.

The epoxy resin (F) used in the present invention also means a resin generally called a phenoxy resin with self-membrane formation ability, a type of high molecular weight epoxy resin.

Mixing ratio of the present curing agent and the epoxy resin (F) is determined in view of hardening property and characteristics of cured material, however, is preferably 0.1 to 100 parts by weight of the capsule type curing agent included in the present the curing agent relative to 100 parts by weight of the epoxy resin (F), more preferably 0.2 to 80 parts by weight and further preferably 0.5 to 60 parts by weight. The ratio of not lower than 0.1 parts by weight can provide practically satisfactory hardening property, while the ratio not higher than 100 parts by weight can provide uniform presence of the capsule type curing agent and good balance in hardening property.

The epoxy resin composition of the present invention can use the curing agent (G) in combination, other than the present curing agent.

The curing agent (G) is selected from a group comprising anhydrides, phenols, hydrazides and guanidines. It can be used in combination of multiple kinds.

Examples of the ahhydrides include , for example, phthalic anhydride, trimellitic anhydride, pyromellitic anhydride, hexahydrophthalic anhydride, tetrahydrophthalic anhydride, 3-chlorophthalic anhydride, 4-chlorophthalic anhydride, benzophenone tetracarboxylic dianhydride, succinic anhydride, methylsuccinic anhydride, dimethylsuccinic anhydride, dichlorosuccinic anhydride, methylnadic anhydride, dodecylsuccinic anhydride, chlorendic anhydride, maleic anhydride, etc.; phenols include, for example, phenol novolac, cresol novolac, bisphenol A novolac, etc.; hydrazides include, for example, succinic acid dihydrazide, adipic acid dihydrazide, phthalic acid dihydrazide, isophthalic acid dihydrazide, p-hydroxybenzoic acid hydrazide, salicylic acid hydrazide, phenylaminopropionic acid hydrazide, maleic acid hydrazide, etc.; guanidines include, for example, dicyandiamide, methylguanidine, ethylguanidine, propylguanidine, butylguanidine, dimethylguanidine, trimethylguanidine, phenylguanidine, diphenylguanidine, toluylguanidine, etc.

Preferable ones as the curing agent (G) are guanidines and anhydrides and further preferable ones are dicyandiamide, hexahydrophthalic anhydride, methyltetrahydrophthalic anhydride and methylnadic anhydride.

When the curing agent (G) is used, it is preferably used in 1 to 200 parts by weight relative to 100 parts by weight of the epoxy resin (E), and the present curing agent is preferably used so that total weight of the capsule type curing agent is 0.1 to 100 parts by weight.

Use within this range can provide a composition superior in hardening property and storage stability and cured material superior in heat resistance and water resistance.

In manufacturing the epoxy resin composition using the present curing agent, extender, reinforcing material, filler material, conductive fine particle, pigment, organic solvent, reactive diluent, non-reactive diluent, resins, coupling agent, and the like can be added, if necessary. As examples of the filler, the following are included: coal tar, glass fiber, asbestos fiber, boron fiber, carbon fiber, cellulose, polyethylene powder, polypropylene powder, quartz powder, mineral silicate salt, mica, asbestos powder, slate powder, kaolin, aluminum oxide trihydrate, aluminum hydroxide, chalk powder, gypsum, calcium carbonate, antimony trioxide, penton, silica, aerosol, lithopone, barytes, titanium dioxide, carbon black, graphite, iron oxide, gold, aluminum powder, iron powder, and the like, and they each can effectively be used depending on applications thereof. The organic solvent includes, for example, toluene, xylene, methylethyl ketone, methylisobutyl, ethyl acetate, n-butyl acetate, etc. Reactive diluents include, for example, butylglycidyl ether, N,N-diglycidyl -o-toluidine, phenyl glycidyl ether, styrene oxide, ethyleneglycol diglycidyl ether, propyleneglycol diglycidyl ether, 1,6-hexanediol diglycidyl ether, etc. Nonreactive diluents include, for example, dioctyl phthalate, dibutyl phthalate, petroleum solvents, etc. Resins include a polyester resin, a polyurethane resin, an acrylic resin, a polyether resin, a melamine resin, a modified epoxy resins such as a urethane-modified epoxy resin, a rubber-modified epoxy resin, an alkyd modified epoxy resin, etc.

The epoxy resin composition of the present invention contains, as main components, the present curing agent and the epoxy resin (F) and, if necessary, the curing agent (G). The epoxy resin composition of the present invention exerts desired performance by a hardening reaction by heating and "main components" here means main components in the hardening reaction by heating and preferably occupies not less than 60% of components to be hardened by heating, further preferably not less than 70%.

Among the epoxy resin composition, those not participating to hardening include, for example, extender, reinforcing material, filler, conductive fine particle, pigment, organic solvent, resins, and the like and these components are preferably used in the range of 0 to 90% by weight in total epoxy resin composition.

The epoxy resin composition of the present invention is useful as adhesives, encapsulant, filler material, insulating material, conductive material, anisotropic conductive material, sealant material, prepreg, etc. As adhesives, it is useful as liquid adhesives, film adhesives, die bonding material, etc. As encapsulant, it is useful as solid encapsulant, liquid encapsulant or film encapsulant and as liquid encapsulant, it is useful as under-fill material, potting material, dam material, etc. As insulating material, it is useful as insulating adhesive film, insulating adhesive paste, solder resist, etc., and as conductive material, it is useful as conductive film, conductive paste, etc., and as anisotropic conductive material, it is useful as anisotropic conductive film, anisotropic conductive paste, etc.

When it is used as conductive material or anisotropic conductive material, a conductive particle can be dispersed and mixed in the epoxy resin composition of the present invention. As the conductive particle, includes a solder particle, a nickel particle, a gradient particle of cupper and silver, and the like, for example, a resin particle of polystyrene resin, polyurethane resin, melamine resin, epoxy resin, acrylic resin, phenol resin, poly(styrenebutadiene)resin, and the like, which are coated with conductive thin film of gold, nickel, silver, copper, solder, etc. Generally, a conductive particle is a fine spherical particle of about 1 to 20 µm size. To make a film, such a method is adopted: a solvent is formulated into the epoxy resin composition, followed by coating on a substrate such as polyester, polyethylene, polyimide, polytetrafluoroethylene, and the like and drying the solvent.

To use as an insulating material or encapsulant, filler such as silica, and the like is added to the composition of the present invention. To use as film, such a method is adopted: a solvent is formulated into the epoxy resin composition, followed by coating on a substrate such as polyester, and the like and drying the solvent.

The present invention is now explained in more detail using Examples, however, technical scope and embodiments to practice the present invention are by no means limited thereto. "Parts" or "%" in Examples and Comparative Examples are weight base unless otherwise specified.

Property evaluation tests on resins and cured material in accordance with the present Examples and Comparative Examples were carried out by the following methods.
(1) Epoxy equivalent
   It means weight (g) of an epoxy resin containing 1 equivalent epoxy group and was determined in accordance with JIS K-7236.
(2) Total chlorine amount
   To 25 ml of ethylene glycol monobutyl ether, 1 g of a sample was dissolved, followed by the addition thereto 25 ml of a propylene glycol solution of 1N KOH, boiling for 20 minutes and titration with an aqueous solution of silver nitrate.
(3) Amount of hydrolyzable chlorines
   To 50 ml of toluene, 3 g of a sample was dissolved, followed by the addition thereto 20 ml of a methanol solution of 1N KOH, boiling for 15 minutes and titration with an aqueous solution of silver nitrate.
(4) Viscosity
   It was measured at 25°C using a BM type viscometer.
(5) Melt viscosity
   It was measured using a RE-550H type viscometer (rotor R-H HH4) from TOKI SANGYO CO., LTD., under conditions of rotation speed of 20 rpm and measurement temperature at 160°C.
(6) FT-IR measurement
   Absorbance was measured using FR/IR-660Plus from JASCO Corporation.
(7) Measurement of ¹³C-NMR spectrum
   It was measured using DSX400 from Brucker Co., Ltd. (magnetic field: 400 MHz). Measurement conditions are: objective nucleous specy ¹³C, pulse program CPSELTICS, pulse conditions (repetition time 5 seconds, 90 degree proton pulse 5.2 micro second, contact time 1 mil second) and magic angle spinning 5000 Hz.
(8) Separation of the capsule type curing agent from the masterbatch type curing agent
   Washing and filtering of the masterbatch type curing agent were repeated using xylene until the epoxy resin was not observed. Then, washing and filtering were repeated with cyclohexane until xylene was not observed, followed by filtering of cyclohexane and complete removal and drying of cyclohexane at temperature not higher than 50°C.
(9) Separation of the capsule membrane from the capsule type curing agent
   Washing and filtering of the epoxy resin composition were repeated using methanol until the amine type curing agent (A) was not observed. Then, methanol was completely removed and dried at temperature not higher than 50°C.
(10) Measurement of gelling time
   It was determined using a Curastmeter V model from T. S. Engineering Co., Ltd. in accordance with JIS K6300.
(11) Storage stability of the epoxy resin composition
   To the epoxy resin composition was mixed a 1/1 mixture solvent of ethyl acetate/toluene in such amount as non-volatile mater was 70%, followed by standing still at 25°C for 1 hour. This solution was coated up to dry coating thickness of 30 µm, followed by drying by heating at 70°C for 5 minutes, removing a solvent in the composition and stored at 50°C for 3 days. After and before storage at 50°C for 3 days, FT-IR measurement was carried out and residual ratios of epoxy groups were calculated from peak height at 914 cm⁻¹ to evaluate storage stability.
(12) Hardening property of the epoxy resin composition
   Gelling time of the epoxy resin composition was measured and hardening property was evaluated based on measurement temperature giving gelling time of below 5 minutes.

### Manufacturing Example 1

### (Manufacturing of an epoxy resin)

A stirrer, a thermometer, a reflux cooling tube and a nitrogen blowing tube were set to a separable flask charged with 100 parts of a bisphenol A-type epoxy resin (epoxy equivalent 175 g/equivalent, total chlorine amount 1160 ppm, total amount of hydrolyzable chlorine 22 ppm: named as the epoxy resin E-1) and 250 parts of toluene, and the mixture was heated to 120°C, while blowing nitrogen into the flask and stirring. Then, 20 ml of 0.5 N bis(trimethylsilyl)amide potassium salt (toluene solution) were added and a dechlorination reaction was carried out at 120°C for 2 hours. After cooling, solid substance was filtered off, followed by neutralization with phosphoric acid, washing with water and removing toluene and water in an organic layer by a rotary evaporator to obtain an epoxy resin B-1. Characteristics values of thus obtained epoxy resin B-1 are shown in Table 1.

### Manufacturing Examples 2 to 4

### (Manufacturing of an epoxy resin)

Epoxy resins B-2 to B-4 were obtained similarly as in Manufacturing Example 1 using formulations and synthesis conditions shown in Table 1. Characteristics values of thus obtained epoxy resins B-2 to B-4 are shown in Table 1.

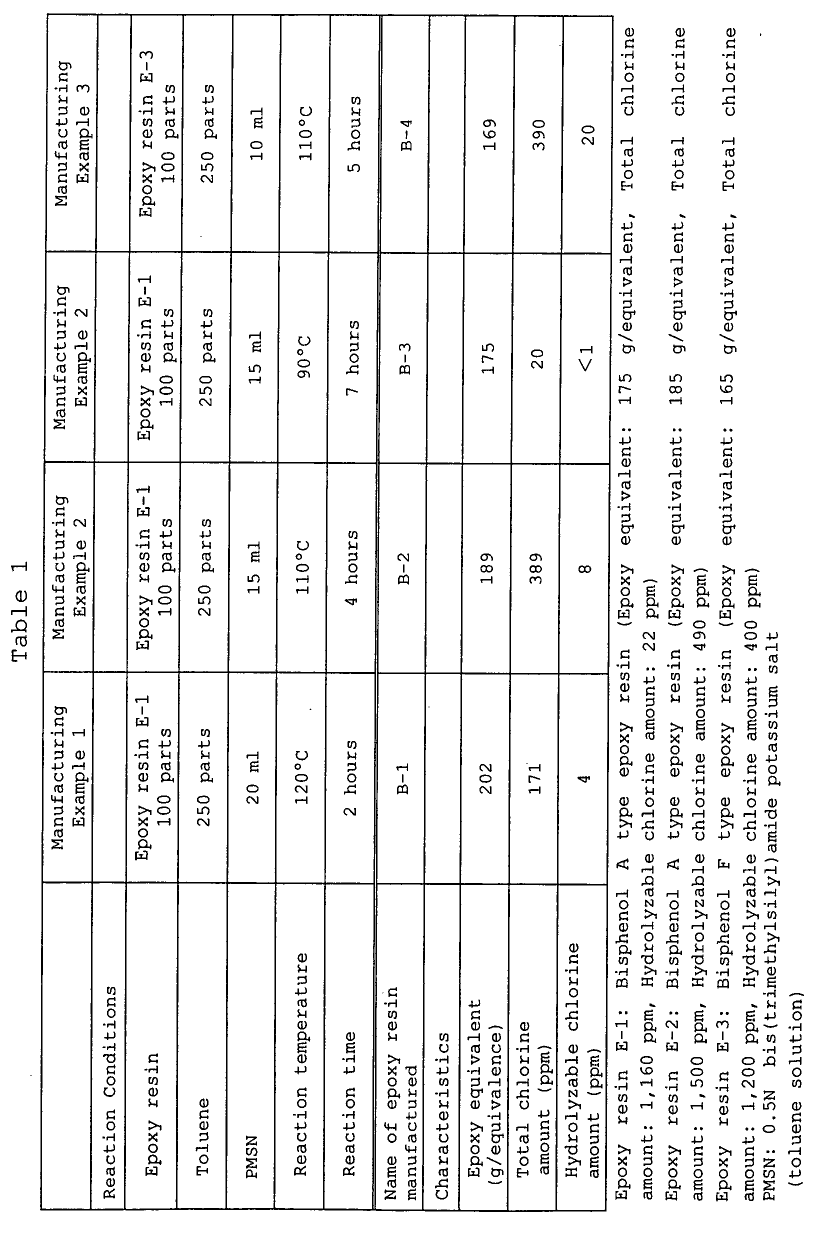

### Manufacturing Example 5

### (Manufacturing of the amine curing agent (A))

The epoxy resin B-1 of 1 mole, diluted to 1/1.25 with a 1/1 mixture solvent of methanol/toluene, was added in drop-wise over 3 hours to 1.5 mole of 2-methylimidazole, diluted to 1/3 with a 1/1 mixture solvent of methanol/toluene, while stirring at 80°C, followed by reaction at 80°C for 2 hours after completion of the drop-wise addition, and removing the solvent at 150°C to 180°C under reduced pressure to obtain a solid compound. By crushing the solid, an amine curing agent A-1 with average particle diameter of 5 µm was obtained. Total chlorine amount of thus obtained amine curing agent A-1 was 110 ppm and melt viscosity was 3.2 Pa·s.

### Manufacturing Example 6

### (Manufacturing of the amine curing agent (A))

A solid compound was obtained by a reaction under similar conditions as in Manufacturing Example 5, except that the epoxy resin was changed to B-2. By crushing the solid, an amine curing agent A-2 having average particle diameter of 5 µm was obtained. Total chlorine amount of thus obtained amine curing agent A-2 was 290 ppm and melt viscosity was 2.7 Pa·s.

### Manufacturing Example 7

### (Manufacturing of the amine curing agent (A))

A solid compound was obtained by a reaction under similar conditions as in Manufacturing Example 5, except that the epoxy resin was changed to B-3. By crushing the solid, an amine curing agent A-3 having average particle diameter of 2 µm was obtained. Total chlorine amount of thus obtained amine curing agent A-3 was 10 ppm and melt viscosity was 3.5 Pa·s.

### Manufacturing Example 8

### (Manufacturing of the amine curing agent (A))

A solid compound was obtained by a reaction between 1 mole of the epoxy resins B-4 and 2 moles of dimethylamine, similarly as in Manufacturing Example 5. By crushing the solid, an amine curing agent A-4 having average particle diameter of 2 µm was obtained. Total chlorine amount of thus obtained amine curing agent A-4 was 350 ppm and melt viscosity was 1.9 Pa·s.

### Manufacturing Example 9

### (Manufacturing of the amine curing agent (A))

A solid compound was obtained similarly as in Manufacturing Example 5, except that a bisphenol A type epoxy resin (epoxy equivalent 185 g/equivalent, total chlorine amount 1500 ppm, amount of hydrolysable chlorine 490 ppm: named as the epoxy resin E-2) was used instead of the epoxy resin B-1. By crushing the solid, an amine curing agent A-5 having average particle diameter of 5 µm was obtained. Total chlorine amount of thus obtained amine curing agent A-5 was 1100 ppm and melt viscosity was 2.0 Pa·s.

### Manufacturing Example 10

### (Manufacturing of the amine curing agent (A))

The epoxy resin B-3 of 1 mole, diluted to 1/1.25 with the 1/1 mixture solvent of methanol/toluene, was charged over 5 minutes to 1.5 mole of 2-methylimidazole, diluted to 1/3 with the 1/1 mixture solvent of methanol/toluene, while stirring at 80°C, followed by reaction at 80°C for 2 hours after completion of the charging, and removing the solvent at 150°C under reduced pressure to obtain a solid compound. By crushing the solid, an amine curing agent A-6 having average particle diameter of 5 µm was obtained. Total chlorine amount of thus obtained amine curing agent A-6 was 14 ppm and melt viscosity was 11.1 Pa·s.

### Example 1

Into a 1 L separable flask equipped with a stirrer and a temperature detector, 200 parts of the epoxy resin E-2, 100 parts of the amine type curing agent A-1 and further 1.5 parts of water were added and mixed uniformly, followed by the addition of 5 parts of tolylenediisocyanate (TDI) and reaction at 40°C for 2 hours, while stirring to react not less than 99% of TDI. Then, a shell forming reaction was carried out at 35°C for 48 hours to obtain the masterbatch type curing agent H-1 containing 39% by weight of the capsule type curing agent.

From the masterbatch type curing agent H-1, the capsule type curing agent was separated using xylene, which was confirmed to have the bonding groups (x), (y) and (z) by FT-IR measurement. Further, the capsule membrane was separated from the amine type curing agent A-1 using methanol, which had ratio of the capsule membrane to the core of 41/100. The capsule membrane had ratio of peak height 1 and peak height 2 of 4.6, measured by ¹³C-NMR spectrum.

A mixture of 30 parts of thus obtained masterbatch type curing agent H-1 and 100 parts of the epoxy resin E-2 was mixed using a three-set roll at output rate of 110 g/minute to obtain an epoxy resin composition.

Storage stability and hardening property of thus obtained epoxy resin composition were evaluated. The evaluation results are shown in Table 2.

### Examples 2 to 9

The masterbatch type curing agents H-2 to H-9 were obtained similarly as in Example 1 under formulations and shell forming conditions shown in Table 2, whose properties were evaluated. Further, epoxy resin compositions were obtained under similar conditions as in Example 1, except that the masterbatch type curing agent was changed to H-2 to H-9 and storage stability and hardening property thereof were evaluated. The evaluation results are shown in Table 2.

### Comparative Example 1

A masterbatch type curing agent H-10 was obtained similarly as in Example 1 under formulation and shell forming conditions shown in Table 2 and properties of the masterbatch type curing agent were evaluated. Further, an epoxy resin composition was obtained under similar conditions as in Example 1, except that the masterbatch type curing agent was changed to H-10 and storage stability and hardening property thereof were evaluated. The evaluation results are shown in Table 2.

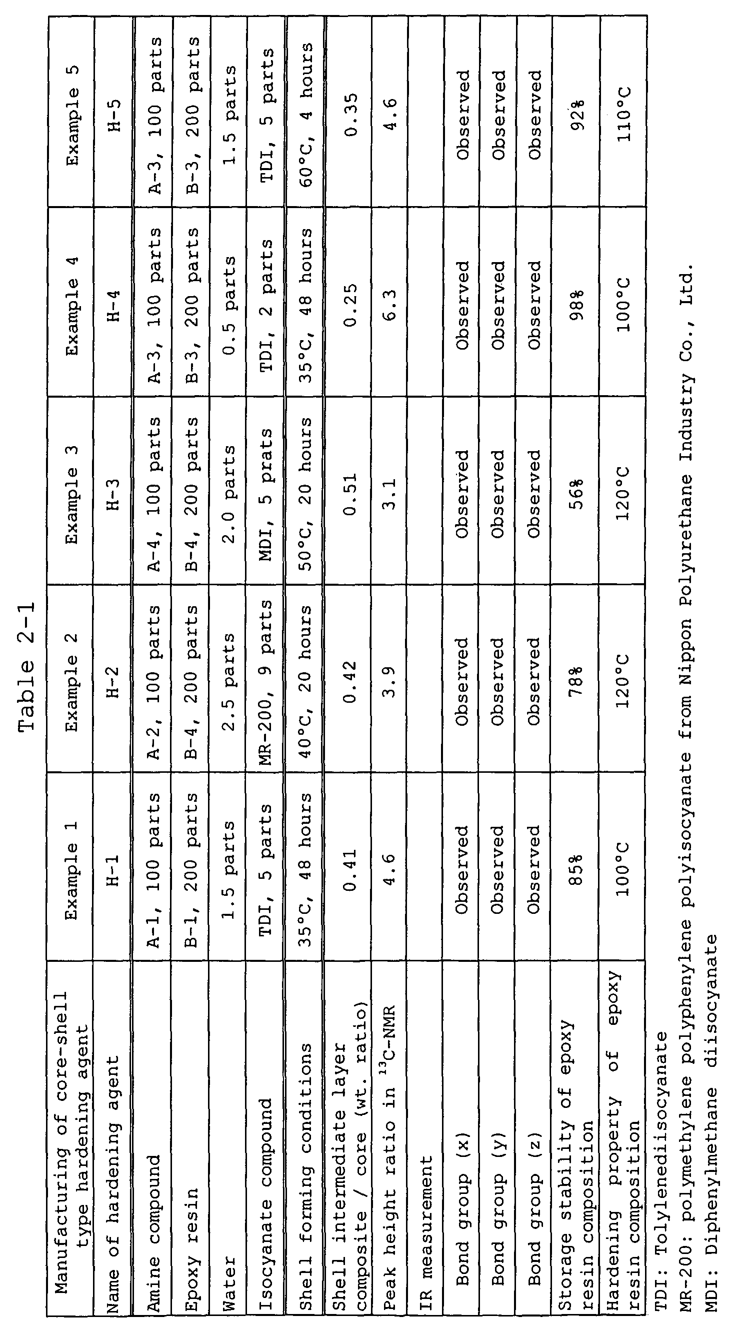

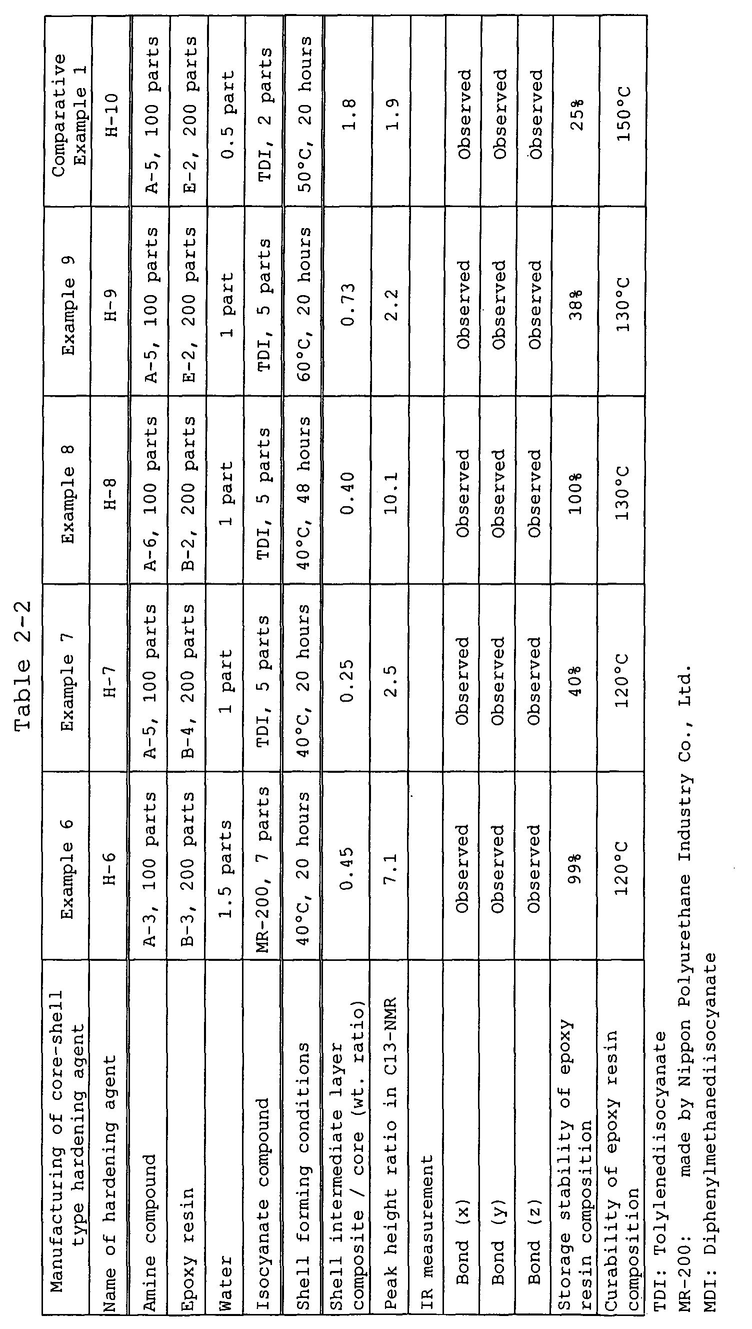

### Example 6

To 8 parts of dicyandiamide, crushed in advance to average particle diameter of 3 µm, 3 parts of the masterbatch type curing agent H-4, 95 parts of the epoxy resin E-2, 5 parts of EP-4023 (CTBN modified epoxy resin from Adeca Co., ltd.) and 20 parts of calcium carbonate were added and mixed uniformly to obtain an epoxy resin composition. Viscosity of thus obtained epoxy resin composition after being stored at 40°C for 1 week was 1.7 times before storage and gelling time at 140°C was 1.2 minute.

### Example 7

To 100 parts of a bisphenol F-type epoxy resin (epoxy equivalent 165 g/equivalent, total chlorine amount 1200 ppm, amount of hydrolyzable chlorine 400 ppm: named as the epoxy resin E-3) were added and mixed uniformly 80 parts of methylhexahydrophthalic anhydride and 300 parts of spherical powders of molten silica (average particle diameter 10 µm), followed by the addition of 6 parts of the masterbatch type curing agent H-4 to obtain liquid encapsulant. Thus obtained liquid encapsulant was sandwiched between a substrate and LSI, followed by heating at 100°C for 3 hours, further heating at 150°C for 3 hours to harden the liquid encapsulant, which was found useful as encapsulant. The encapsulant of the present composition was also useful as insulating adhesive paste.

### Example 8

To 30 parts of ethyl acetate, 40 parts of a bisphenol A-type epoxy resin (epoxy equivalent 2500 g/equivalent) was dissolved, to which were added 60 parts of the masterbatch type curing agent H-4 and 10 parts of conductive particles with particle diameter of 8 µm (crosslinked polystyrene plated with gold) and mixed uniformly to obtain an epoxy resin composition. This composition was coated on a polyester film and ethyl acetate was removed by drying at 70°C to obtain an anisotropic conductive film. Thus obtained anisotropic conductive film was sandwiched between electrodes and hot compressed on a 200°C hot plate under 30 kg/cm² for 20 seconds, resulting in electrical conduction between the electrodes. This was useful as an anisotropic conductive material.

### INDUSTRIAL APPLICABILITY

According to the present invention, a capsule type curing agent to provide cured material having compatible low temperature hardening property and storage stability, along with good balanced performance in electrical characteristics, mechanical strength, heat resistance, humidity resistance, and the like, and an epoxy resin composition can be obtained. Epoxy resin compositions using the capsule type curing agent of the present invention fulfill superior performance as adhesives, encapsulant, filler material, insulating material, conductive material, prepreg, film adhesives, anisotropic conductive film, anisotropic conductive paste, insulating adhesive film, insulating adhesive paste, under-fill material, potting material, die bonding material, conductive paste, solder resist, etc.

## Claims

1. A capsule type curing agent which comprises a core comprising an amine type curing agent (A) and a capsule and a membrane covering said core, wherein said capsule membrane has a bonding group (x) absorbing infrared ray of a wave-number of 1630 to 1680 cm⁻¹ and/or a bonding group (y) absorbing infrared ray of a wave-number of 1680 to 1725 cm⁻¹, and contains cured material of an epoxy resin by the amine type curing agent (A) as a curing agent, and weight ratio of the core and the capsule membrane is 100:1 to 100:100.

2. The capsule type curing agent according to Claim 1, wherein in ¹³C-NMR spectrum of the capsule membrane, ratio of a largest peak height between 37 to 47 ppm to a largest peak height between 47 to 57 is not lower than 3.

3. The capsule type curing agent according to Claim 1 or 2, wherein melt viscosity of the amine type curing agent (A) at 160°C is not higher than 10 Pa·s.

4. The capsule type curing agent according to any one of Claims 1 to 3, wherein the amine type curing agent (A) has at least one tertiary amino group in one molecule thereof.

5. The capsule type curing agent according to any one of Claims 1 to 4, wherein total amount of chlorines in the amine type curing agent (A) is not more than 400 ppm.

6. The capsule type curing agent according to any one of Claims 1 to 5, wherein the amine type curing agent (A) is a reaction product between an epoxy resin (B) having total amount of chlorines of not more than 400 ppm and an amine compound (C).

7. The capsule type curing agent according to any one of Claims 1 to 6, wherein total amount of chlorines in an epoxy resin (D) is not more than 400 ppm.

8. The capsule type curing agent according to any one of Claims 1 to 7, wherein the capsule membrane is comprised of a shell of a reaction product between the amine type curing agent (A) and the epoxy resin (D) and an intermediate layer having the bonding group (x) and/or the bonding group (y).

9. A masterbatch type curing agent comprising 100 parts by weight of the capsule type curing agent according to any one of Claims 1 to 8 and 10 to 50,000 parts by weight of an epoxy resin (E).

10. An epoxy resin composition comprising, as main components, 100 parts by weight of an epoxy resin (F) and the capsule type curing agent according to any one of Claims 1 to 8 or the masterbatch type curing agent according to Claim 9 or a mixture thereof in such an amount as the total amount of the capsule type curing agents is 0.1 to 100 parts by weight.

11. An epoxy resin composition comprising, as main components, 100 parts by weight of the epoxy resin (F), 1 to 200 parts by weight of at least one kind of a curing agent (G) selected from the group consisting of acid anhydrides, phenols, hydrazides and guanidines, and the capsule type curing agent according to any one of Claims 1 to 8 or the masterbatch type curing agent according to Claim 9 or a mixture thereof in such an amount as the total amount of the capsule type curing agent is 0.1 to 100 parts by weight.

12. An anisotropic conductive material containing the epoxy resin composition according to Claim 10 or 11.

13. A conductive adhesive material containing the epoxy resin composition according to Claim 10 or 11.

14. An insulating adhesive material containing the epoxy resin composition according to Claim 10 or 11.

15. An encapsulant containing the epoxy resin composition according to Claim 10 or 11.
